# EUROPEAN PATENT APPLICATION

(11) **EP 4 746 592 A1**
(43) Date of publication of application: **20.05.2026**
(21) Application number: 24854314.2
(22) Date of filing: 10.07.2024
(51) Int. Cl.: H05K 1/18, H05K 3/34, H05K 1/11

(54) **PRINTED CIRCUIT BOARD ASSEMBLY AND MANUFACTURING METHOD THEREFOR**

(30) Priority: 13.08.2023 KR 20230105986; 04.10.2023 KR 20230131994
(71) Applicant: Samsung Electronics Co., Ltd., Suwon-si, Gyeonggi-do 16677 (KR)
(72) Inventor: KIM, Juho, Suwon-si Gyeonggi-do 16677 (KR); PARK, Woochul, Suwon-si Gyeonggi-do 16677 (KR); KIM, Kiwoong, Suwon-si Gyeonggi-do 16677 (KR); MIN, Yousok, Suwon-si Gyeonggi-do 16677 (KR)
(74) Representative: Gulde & Partner
(86) International application number: PCT/KR2024/009853
(87) International publication number: WO 2025/037762

(57) **Abstract**

A printed circuit board assembly according to an embodiment of the present disclosure may include an electronic component. The printed circuit board assembly may include a printed circuit board (PCB) on which the electronic component is disposed. The printed circuit board assembly may include a plurality of solder members electrically connecting the electronic component with the printed circuit board between the electronic component and the printed circuit board. The printed circuit board assembly may include a plurality of protrusions disposed on the printed circuit board to be spaced apart from the plurality of solder members and positioned near an edge of the electronic component. The printed circuit board assembly may include a filling member filling the edge of the electronic component between the printed circuit board and the electronic component. The distribution of the filling member may be promoted by an adhesive force between the filling member and the plurality of protrusions and a cohesive force of the filling member while the filling member in a liquid state is filled between the printed circuit board and the electronic component.

## Description

### [Technical Field]

The disclosure relates to a printed circuit board assembly including an electronic component and a circuit board on which the electronic component is mounted, and a method for manufacturing the same.

### [Background Art]

Electronic devices are becoming increasingly downsized and multifunctional according to the rapid development of the electronics industry and user demands. Accordingly, the need for miniaturization and multifunctionalization of electronic components (e.g., semiconductor device components) used in electronic devices is also increasing.

An electronic component may be mounted (or disposed) on a circuit board (e.g., printed circuit board (PCB)) using surface mount technology (SMT). The electronic component may be physically connected and electrically connected to the circuit board through a plurality of solder members.

Generally, a plurality of solder members may be disposed in an inner area between the circuit board and the electronic component. The plurality of solder members may not be disposed in an edge area between the circuit board and the electronic component according to a design structure. In this case, the electronic component may have somewhat lower reliability compared to an electronic component having a different design structure.

### [DISCLOSURE OF INVENTION]

### [Solution to Problems]

Various embodiments of the disclosure may provide a printed circuit board assembly including a plurality of protrusions formed in an edge area of a circuit board where a plurality of solder members are not disposed and a filling member filled in the edge area of the circuit board along the plurality of protrusions.

A printed circuit board assembly according to an embodiment of the disclosure may include an electronic component. The printed circuit board assembly may include a printed circuit board (PCB) on which the electronic component is mounted. The printed circuit board assembly may include a plurality of solder members electrically connecting the electronic component and the printed circuit board between the electronic component and the printed circuit board. The printed circuit board assembly may include a plurality of protrusions disposed to be spaced apart from the plurality of solder members on the printed circuit board and positioned near an edge of the electronic component. The printed circuit board assembly may include a filling member filling the edge of the electronic component between the printed circuit board and the electronic component. Distribution of the filling member may be facilitated by an adhesion force between the filling member and the plurality of protrusions, and a cohesion force of the filling member during filling of the filling member in a liquid state between the printed circuit board and the electronic component.

A method for manufacturing a printed circuit board assembly including a printed circuit board on which an electronic component is disposed according to an example of the disclosure may include forming a plurality of protrusions in an edge area of the printed circuit board spaced apart from a soldering area of the printed circuit board where a plurality of solder members are disposed. The method for manufacturing the printed circuit board assembly may include applying a soldering material to a plurality of connection pads disposed in the soldering area. The method for manufacturing the printed circuit board assembly may include disposing the electronic component on the printed circuit board such that the plurality of protrusions and an edge of the electronic component face each other. The method for manufacturing the printed circuit board assembly may include filling a filling member between the plurality of protrusions. Distribution of the filling member may be facilitated by an adhesion force between the filling member and the plurality of protrusions, and a cohesion force of the filling member B during the filling of the filling member in a liquid state between the printed circuit board and the electronic component.

According to various embodiments of the disclosure, as a plurality of protrusions are formed in an edge area of a circuit board where a plurality of solder members are not disposed, a filling member may be evenly filled (or applied) in the edge area along the plurality of protrusions. In this case, an electronic component may be firmly mounted on a substrate by a plurality of solder members and a filling member, thereby enhancing reliability of a printed circuit board assembly.

Effects of the present invention are not limited to the foregoing, and other unmentioned effects would be apparent to one of ordinary skill in the art from the following description. In other words, unintended effects in practicing embodiments of the disclosure may also be derived by one of ordinary skill in the art from example embodiments of the disclosure.

### [BRIEF DESCRIPTION OF DRAWINGS]

In connection with the description of the drawings, the same or similar reference numerals may be used to denote the same or similar elements.
FIG. 1 is a plan view illustrating a printed circuit board assembly according to an embodiment of the disclosure;
FIG. 2A is a cross-sectional view illustrating the printed circuit board assembly taken along line I-I' illustrated in FIG. 1;
FIG. 2B is a partial cross-sectional view illustrating the printed circuit board assembly illustrating a state before a filling member is filled, according to an embodiment of the disclosure;
FIG. 3 is a partial cross-sectional view illustrating the printed circuit board assembly illustrating a state in which a filling member is filled, according to an embodiment of the disclosure;
FIG. 4 is an enlarged view of portion A of FIG. 1;
FIG. 5 is a cross-sectional view illustrating cross-sectional shapes of a plurality of protrusions according to an embodiment of the disclosure;
FIG. 6 is a view illustrating an arrangement of a plurality of protrusions according to an embodiment of the disclosure;
FIG. 7 is a view illustrating an arrangement of a plurality of protrusions according to an embodiment of the disclosure;
FIG. 8 is a view illustrating an arrangement of a plurality of protrusions according to an embodiment of the disclosure;
FIG. 9 is a view illustrating an arrangement of a plurality of protrusions according to an embodiment of the disclosure;
FIG. 10 is a view illustrating an arrangement of a plurality of protrusions according to an embodiment of the disclosure;
FIG. 11 is a view illustrating an arrangement of a plurality of protrusions according to an embodiment of the disclosure;
FIG. 12 is a view illustrating an arrangement of a plurality of protrusions according to an embodiment of the disclosure;
FIG. 13 is a view illustrating an arrangement of a plurality of protrusions according to an embodiment of the disclosure;
FIG. 14 is a view illustrating an arrangement of a plurality of protrusions according to an embodiment of the disclosure;
FIG. 15 is a view illustrating an arrangement of a plurality of protrusions according to an embodiment of the disclosure;
FIG. 16 is a view illustrating an arrangement of a plurality of protrusions according to an embodiment of the disclosure;
FIG. 17 is a view illustrating a filling range of a filling member on a circuit board according to an embodiment;
FIG. 18 is a manufacturing process diagram illustrating a printed circuit board assembly according to an embodiment of the disclosure;
FIG. 19 is a process diagram illustrating a forming process of a plurality of protrusions according to an embodiment of the disclosure;
FIG. 20 is a process diagram illustrating a forming process of a plurality of protrusions according to an embodiment of the disclosure;
FIG. 21 is a plan view illustrating a printed circuit board assembly according to a comparative embodiment of the disclosure;
FIG. 22 is a cross-sectional view illustrating the printed circuit board assembly taken along line II-II' illustrated in FIG. 21 according to a comparative embodiment of the disclosure;
FIG. 23 is a view illustrating a filling range of a filling member in a circuit board of the disclosure according to a comparative embodiment of the disclosure;
FIG. 24 is a view illustrating a crack state of a solder member occurring in case that a filling member is under-filled;
FIG. 25 is a view illustrating a filling range of a filling member on a circuit board according to a comparative embodiment of the disclosure; and
FIG. 26 is a view illustrating a crack state of a solder member occurring in case that a filling member is over-filled;

### [MODE FOR THE INVENTION]

It should be appreciated that various embodiments of the present disclosure and the terms used therein are not intended to limit the technological features set forth herein to particular embodiments and include various changes, equivalents, or replacements for a corresponding embodiment.

With regard to the description of the drawings, similar reference numerals may be used to refer to similar or related elements.

It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases.

As used herein, such terms as "1st" and "2nd," or "first" and "second" may be used to simply distinguish a corresponding component from another, and does not limit the components in other aspect (e.g., importance or order).

It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

It will be further understood that the terms "comprise" and/or "have," as used herein, specify the presence of stated features, integers, steps, operations, elements, and/or components, but do not preclude the presence or addition of one or more other features, integers, steps, operations, elements, components, and/or groups thereof.

It will be understood that when a component is referred to as "connected to," "coupled to", "supported on," or "contacting" another component, the components may be connected to, coupled to, supported on, or contact each other directly or via a third component.

Throughout the specification, when one component is positioned "on" another component, the first component may be positioned directly on the second component, or other component(s) may be positioned between the first and second component.

The term "and/or" may denote a combination(s) of a plurality of related components as listed or any of the components.

Hereinafter, the working principle and embodiments of the present invention are described with reference to the accompanying drawings.

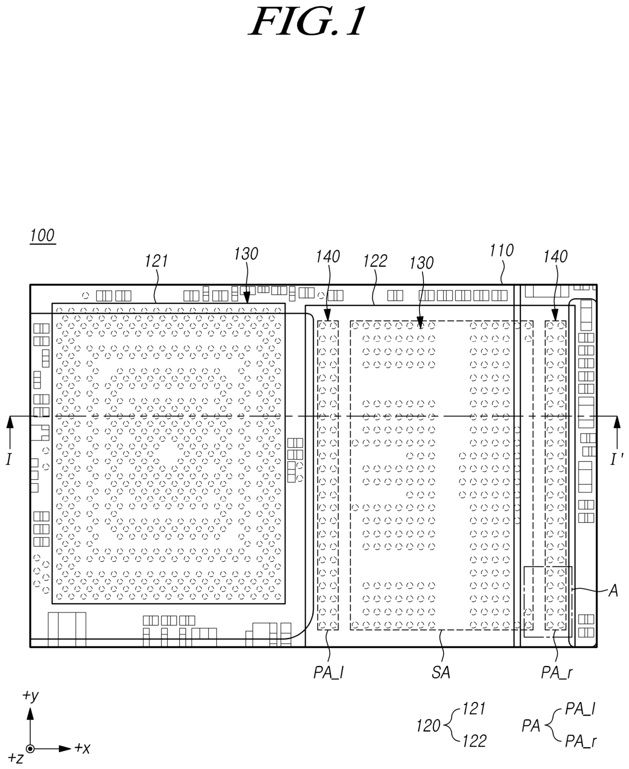

FIG. 1 is a plan view illustrating a printed circuit board assembly according to an embodiment of the disclosure.

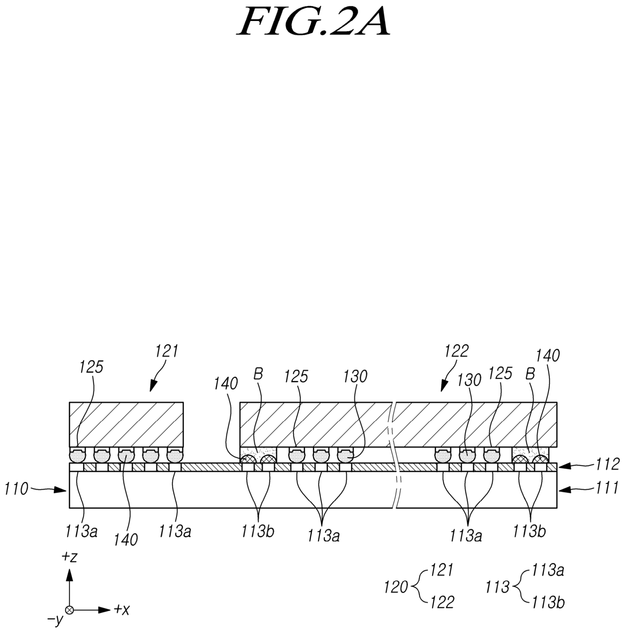

FIG. 2A is a cross-sectional view illustrating the printed circuit board assembly taken along line I-I' illustrated in FIG. 1.

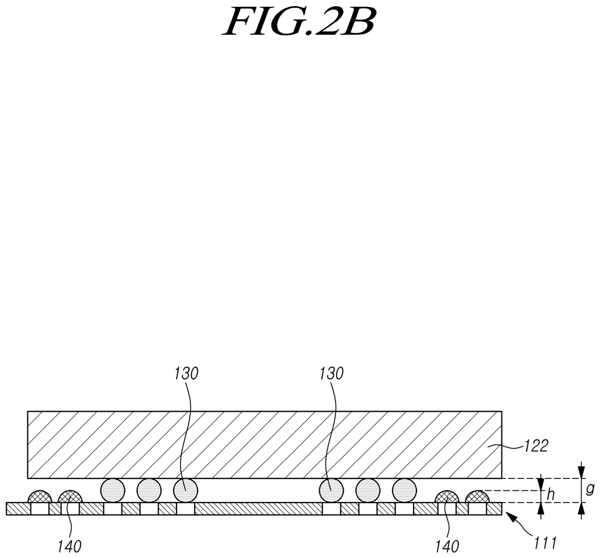

FIG. 2B is a partial cross-sectional view illustrating the printed circuit board assembly illustrating a state before a filling member is filled, according to an embodiment of the disclosure.

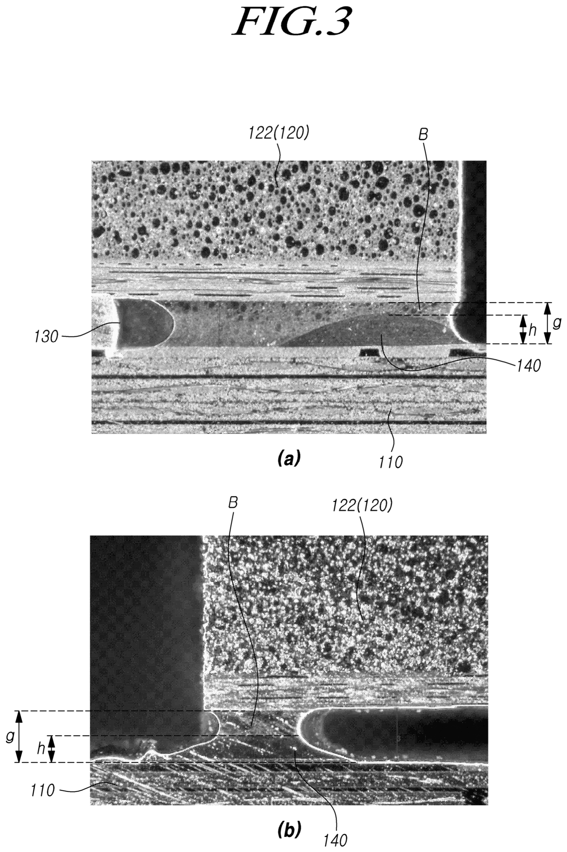

FIG. 3 is a partial cross-sectional view illustrating the printed circuit board assembly illustrating a state in which a filling member is filled, according to an embodiment of the disclosure.

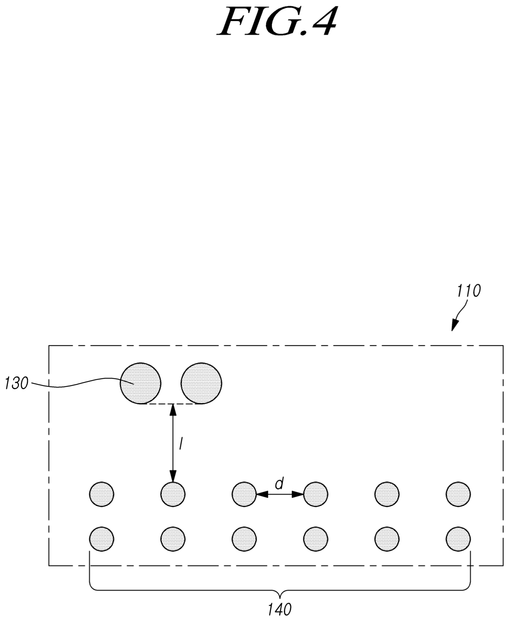

FIG. 4 is an enlarged view of portion A of FIG. 1.

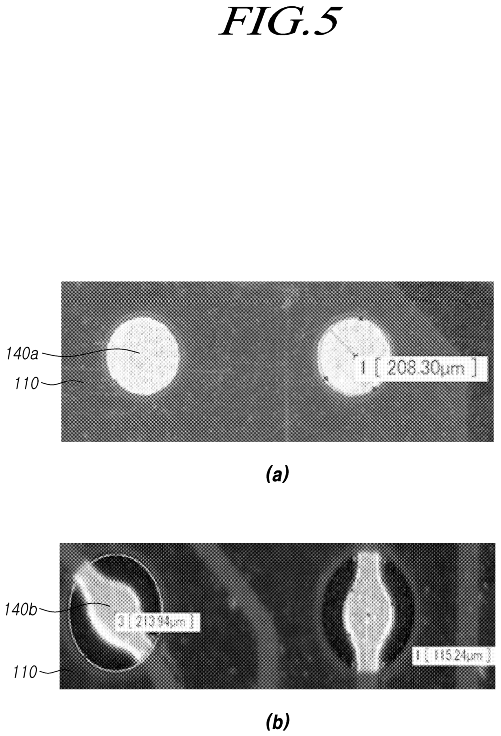

FIG. 5 is a cross-sectional view illustrating cross-sectional shapes of a plurality of protrusions according to an embodiment of the disclosure.

A printed circuit board assembly (100) according to an example of the disclosure may be implemented as various types of modules such as a solid state drive (SSD) module, a memory module, a computer system module, or a mobile system module. For example, the printed circuit board assembly (100) may correspond to a semiconductor module.

Hereinafter, in describing the disclosure, the printed circuit board assembly (100) implemented as a semiconductor module is described as an example, but the disclosure is not limited thereto.

Referring to FIGS. 1 to 5, a printed circuit board assembly (PBA) (100) according to an example may include a circuit board (e.g., printed circuit board (PCB)) (110), at least one electronic component (120), a plurality of solder members (130), a plurality of protrusions (140), and/or a filling member B.

According to an example, various components (e.g., electronic components) constituting the printed circuit board assembly (100) may be mounted or disposed on the circuit board (110).

According to an example, the circuit board (110) may be provided with circuit traces on at least one surface to electrically connect various components mounted on the circuit board (110). In an example, the circuit board (110) may be configured as a substrate for a single layer PCB having circuit traces formed on only one surface. In an example, the circuit board (110) may be configured as a substrate for a double layer PCB having circuit traces formed on two opposite surfaces. For example, in case that the circuit board (110) is configured for a double layer PCB, upper and lower circuit traces may be electrically connected through a conductive via structure (e.g., conductive via hole) penetrating the circuit board (110) (specifically, a substrate body (111) described below).

According to an example, the circuit board (110) may include a substrate body (111), a protective layer (112), and/or a plurality of substrate pads (113).

According to an example, the substrate body (111) may include a body layer formed by compressing various resins such as glass epoxy (or FR-4) resin, phenol resin, or BT resin to a predetermined thickness, and circuit traces formed on the body layer. The circuit traces may be formed by, e.g., patterning a copper foil coated on the body layer.

In an example, the substrate body (111) may have a structure in which the number of copper foil layers is formed to be three or more using an insulator called prepreg, and circuit traces is formed in three or more layers according to the number of copper foil layers, but the disclosure is not limited thereto.

According to an example, the protective layer (112) may be disposed on an upper side (e.g., +z-axis direction) of the substrate body (111). In an example, the protective layer (112) may be configured to protect the circuit traces formed on the substrate body (111). The protective layer (112) may be formed of, e.g., a solder resist (SR) covering the circuit traces. The protective layer (112) may have a structure that covers the circuit traces while opening portions of the plurality of substrate pads (113) to the outside.

According to an example, the plurality of substrate pads (113) may be disposed on at least an upper surface (e.g., a surface facing the +z-axis direction) or a lower surface (e.g., a surface facing the -z-axis direction) of the circuit board (110). Although not specifically illustrated in the drawings, the plurality of substrate pads (113) may also be electrically connected to other substrates in addition to the electronic component (120). In an example, the plurality of substrate pads (113) may be provided on the substrate body (111). In an example, the plurality of substrate pads (113) may be disposed on substantially the same plane (e.g., X-Y plane) as the protective layer (112), but the disclosure is not limited thereto.

According to an example, the plurality of substrate pads (113) may have various shapes. For example, the plurality of substrate pads (113) may have shapes such as circular, polygonal, or ring shapes, but the disclosure is not limited thereto.

According to an example, the plurality of substrate pads (113) may include a plurality of connection pads (113a) and/or a plurality of dummy pads (113b).

According to an example, the plurality of connection pads (113a) may be electrically connected to at least one electronic component (120). In an example, each of the plurality of connection pads (113a) may electrically connect the electronic component (120) and the circuit board (110) through the plurality of solder members (130).

According to an example, the plurality of connection pads (113a) may be provided integrally with the circuit traces as a portion of the circuit traces, or may be provided as separate components on the circuit traces. The plurality of connection pads (113a) may be referred to as, e.g., electrode pads, contact pads, solder pads, or soldering pads. The plurality of connection pads (113a) may be formed of at least one of, e.g., aluminum (Al), copper (Cu), nickel (Ni), tungsten (W), platinum (Pt), or gold (Au).

According to an example, the plurality of connection pads (113a) may be disposed on a lower side (e.g., -z-axis direction) of the electronic component (120). In an example, the plurality of connection pads (113a) may be disposed on the circuit board (110) to overlap the electronic component (120). In an example, the plurality of connection pads (113a) may be disposed in a soldering area SA where the plurality of solder members (130) are disposed. In this case, as illustrated in FIG. 1, in case of viewing the printed circuit board assembly (100) from top to bottom, the plurality of connection pads (113a) are hidden by the electronic component (120).

According to an example, the plurality of dummy pads (113b) are not related to electrical connection to the electronic component (120) and may be formed on the circuit board (110) as an intermediary for fixing the protrusions (140).

According to an example, the plurality of dummy pads (113b) may be formed in one process together with the plurality of connection pads (113a). However, the disclosure is not limited thereto, and the plurality of dummy pads (113b) may be omitted considering a forming process of the plurality of protrusions (140) and design conditions of the circuit board

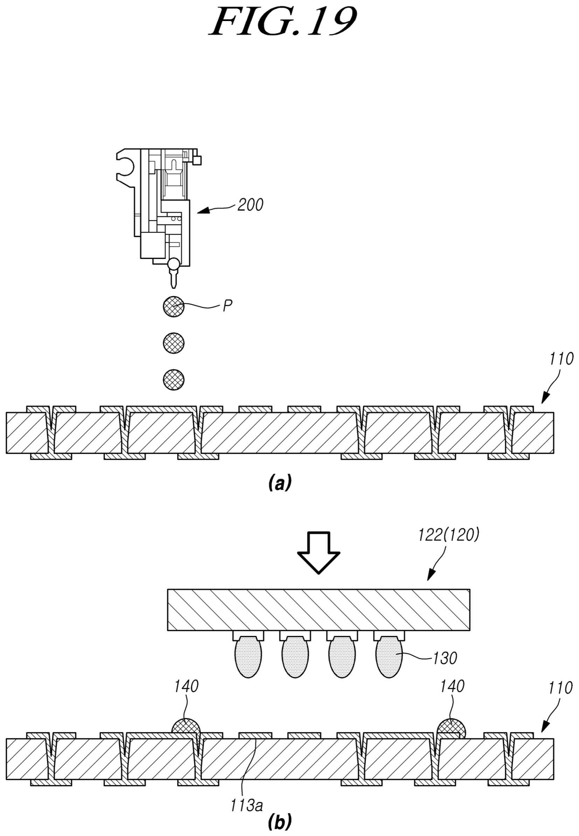

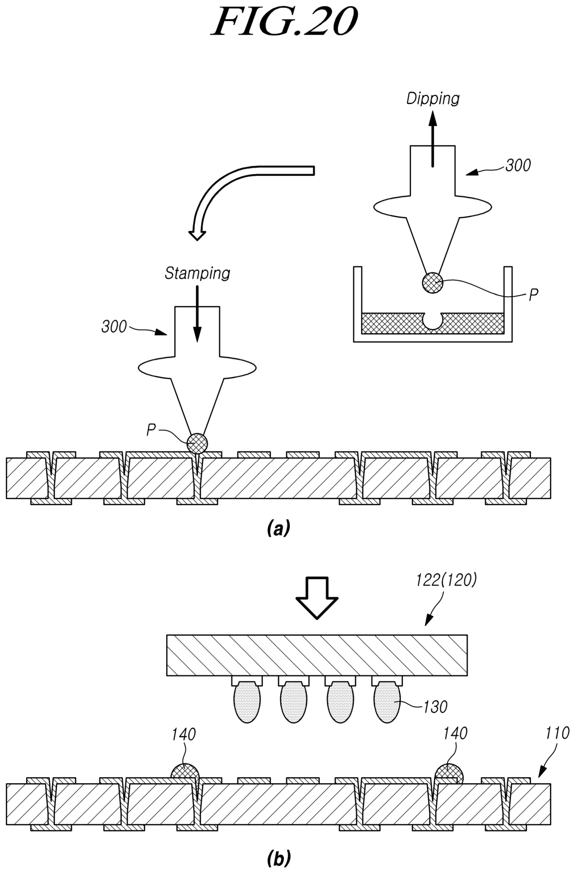

(110). For example, in case of forming the plurality of protrusions (140) using a bonding member P described below, the plurality of dummy pads (113b) may be omitted. Hereinafter, the forming process of the plurality of protrusions (140) using the bonding member P is described in detail with reference to FIGS. 19 and 20.

According to an example, the plurality of dummy pads (113b) may be disposed on a lower side (e.g., -z-axis direction) of the electronic component (120). In an example, the plurality of dummy pads (113b) may be disposed on the circuit board (110) to overlap the electronic component (120) (e.g., the second electronic component 122). In an example, the plurality of dummy pads (113b) may be disposed in a periphery (or vicinity) of the soldering area SA. For example, the plurality of dummy pads (113b) may be spaced apart from the plurality of connection pads (113a). In an example, the plurality of dummy pads (113b) may be disposed in an edge area PA where the plurality of solder members (130) are not disposed. The edge area PA may mean an area formed between the second electronic component (122) and the circuit board (110), adjacent to or facing an edge or boundary of the second electronic component (122) in case that the second electronic component (122) is mounted (or disposed) on the circuit board (110).

According to an example, the edge area PA may include a first edge area PA_l formed on a left side (e.g., -x-axis direction) with respect to the soldering area SA and a second edge area PA_r formed on a right side (e.g., +x-axis direction) with respect to the soldering area SA.

In an example, the first edge area PA_l may be formed to extend along a vertical direction (e.g., ±y-axis direction) on the circuit board (110). In an example, the second edge area PA_r may be formed to extend along the vertical direction (e.g., ±y-axis direction) on the circuit board (110).

Although not specifically illustrated in the drawings, the edge area PA may be formed in various shapes to overlap the second electronic component (122) according to an electrical connection structure of the second electronic component (122), e.g., an arrangement form of the plurality of solder members (130) and/or an arrangement form of a plurality of contact points (125) described below. For example, unlike that illustrated in FIG. 1, the edge area PA may be formed on all four sides of the soldering area SA to surround the soldering area SA. In this case, as illustrated in FIG. 1, in case of viewing the printed circuit board assembly (100) from top to bottom, the plurality of dummy pads (113b) are hidden by the electronic component (120).

According to an example, at least one electronic component (120) may be mounted (or disposed) on the circuit board (110). For example, at least one electronic component (120) may be mounted on at least one surface (e.g., upper surface or lower surface) of the circuit board (110). In an example, at least one electronic component (120) may be electrically/physically connected to the circuit board (110) through the plurality of solder members (130).

According to an example, at least one electronic component (120) may include various elements such as passive elements and/or active elements. At least one electronic component (120) may be any element that may be mounted (or disposed) on the circuit board (110).

In an example, at least one electronic component (120) may include a plurality of contact points (125) formed on one surface (e.g., lower surface) facing the circuit board (110) in case that the electronic component (120) is mounted (or disposed) on the circuit board (110). In an example, the plurality of contact points (125) may contact the plurality of solder members (130). The plurality of contact points (125) may be electrically connected to the plurality of connection pads (113a) provided on the circuit board (110) through the plurality of solder members (130).

According to an example, at least one electronic component (120) may be a chip package including at least one semiconductor chip. For example, the electronic component (120) may include at least one memory chip or logic chip therein. For example, in case that the electronic component (120) includes a memory chip, the electronic component (120) may be a memory element including memory such as dynamic random access memory (DRAM), static random access memory (SRAM), flash memory, electrically erasable programmable read-only memory (EEPROM), phase-change random access memory (PRAM), magnetoresistive random access memory (MRAM), or resistive random access memory (RRAM). For example, in case that the electronic component (120) includes a logic chip, the electronic component (120) may be a logic element including a relatively small-sized logic chip.

In an example, at least one electronic component (120) may include elements such as a connector, a controller, or an electrolytic cap. Here, the electrolytic cap may be a unipolar capacitor, may have a large capacitance, and may be used for a low frequency filter or a bypass.

In an example, at least one electronic component (120) may include a chip package such as a generally large-sized micro-processor, central processing unit (CPU), controller, or application specific integrated circuit (ASIC).

In an example, at least one electronic component (120) may also include a system on chip (SoC) type application processor (AP) used in mobile electronic devices.

The types of at least one electronic component (120) are not limited to the above-described elements.

In an example, at least one electronic component (120) may be mounted (or disposed) on the circuit board (110) through surface mount technology (SMT). The SMT may mean a so-called automatic soldering technology that automatically mounts an electronic component on a surface of the circuit board (110) using a soldering material (or solder paste). For example, the SMT may denote a technology of automatically mounting (or disposing) electronic components such as semiconductors, diodes, and chips on a substrate using equipment such as a chip mounter or multi mounter using a soldering material and curing them. In such SMT, heat and pressure may be applied to facilitate bonding of the corresponding electronic component with the soldering material.

According to an example, at least one electronic component (120) may include a first electronic component (121) and a second electronic component (122).

According to an example, the first electronic component (121) may correspond to an electronic component having substantially the same size as a soldering area SA where the plurality of solder members (130) are disposed. The first electronic component (121) may correspond to, e.g., an AP-related component.

According to an example, the second electronic component (122) may correspond to a component having a different size from the first electronic component (121). For example, the second electronic component (122) may have a larger size than the first electronic component (121).

According to an example, the second electronic component (122) may correspond to an electronic component having a different size from the soldering area SA where the plurality of solder members (130) are disposed. The second electronic component (122) may correspond to, e.g., an electronic component including the soldering area SA and the edge area PA. The second electronic component (122) may correspond to, e.g., a memory-related component.

According to an example, the plurality of solder members (130) may be disposed on the circuit board (110) to overlap the electronic component (120). In an example, the plurality of solder members (130) may be disposed on the plurality of connection pads (113a). In an example, the plurality of solder members (130) may be disposed in the soldering area SA. In an example, the plurality of solder members (130) may physically/electrically connect at least one electronic component (120) and the circuit board (110). For example, the second electronic component (122) may be firmly mounted (or disposed) on the circuit board (110) by the plurality of solder members (130) and the filling member B described below. In an example, the plurality of solder members (130) may include solder balls.

According to an example, the plurality of protrusions (140) may be disposed on the circuit board (110) to overlap the second electronic component (122). In an example, the plurality of protrusions (140) may be disposed on the plurality of dummy pads (113b). For example, the plurality of protrusions (140) may be formed by a soldering process to be disposed on the plurality of dummy pads (113b). The plurality of protrusions (140) may be formed of a soldering material, but the disclosure is not limited thereto. For example, the plurality of protrusions (140) may also be formed by the bonding member P described below, and this is described below with reference to FIGS. 19 and 20.

In an example, the plurality of protrusions (140) may be disposed in the edge area PA. In an example, the plurality of protrusions (140) may be disposed in the edge area PA in at least one or more rows.

According to an example, the plurality of protrusions (140) may have various shapes such as hemispherical shape, cylindrical shape, or polyhedral shape, but the disclosure is not limited thereto. For example, the shape of the plurality of protrusions (140) may be designed considering a filling amount and/or a filling area (or filling range) of the filling member B in case of filling the filling member B. This is because resistance to flow of the filling member B varies according to the shape of the plurality of protrusions (140) in case of filling the filling member B. For example, the plurality of protrusions (140a) may be designed to have a circular cross-section cut along the X-Y plane, as illustrated in FIG. 5(a). For example, the plurality of protrusions (140b) may be designed to have a bar shape with a convex center in a cross-section cut along the X-Y plane, as illustrated in FIG. 5(b).

According to an example, the plurality of protrusions (140) may be disposed to be spaced apart from each other at a predetermined interval. For example, a spacing d between the plurality of protrusions (140) may be 0.4 mm or more, but the disclosure is not limited thereto. The spacing d between the plurality of protrusions (140) may be designed considering the filling amount and/or filling area (or filling range) of the filling member B in case of filling the filling member B. The filling area of the filling member B may also be referred to as an overlapping area or bonding area as an area where the filling member B contacts the second electronic component (122) and the circuit board (110). For example, in case that the spacing d between the plurality of protrusions (140) is decreased, capillary action becomes more active, and the filling amount and/or filling area of the filling member B may increase. Here, the capillary action may mean a phenomenon in which the filling member B flows from the edge area PA to the soldering area SA along between the plurality of protrusions (140) due to cohesion of the filling member B and adhesion between the filling member B and the plurality of protrusions (140). In this case, the second electronic component (122) may be firmly mounted (or disposed or fixed) on the circuit board (110).

According to an example, the plurality of protrusions (140) may be disposed to be spaced apart from the plurality of solder members (130) at a predetermined interval. For example, a spacing distance l between the plurality of protrusions (140) and the plurality of solder members (130) may be designed within a range of 0.9 mm to 2.0 mm, but the disclosure is not limited thereto. The spacing distance l between the plurality of protrusions (140) and the plurality of solder members (130) may be designed considering the filling amount and/or filling area (or filling range) of the filling member B in case of filling the filling member B. For example, the spacing distance l may be designed within a range where the filled filling member B does not contact the plurality of solder members (130) in case of filling the filling member B.

According to an example, the plurality of protrusions (140) may protrude to a predetermined height h from a surface of the circuit board (110). In an example, a protruding height h of the plurality of protrusions (140) may be designed to be lower than a gap g between the circuit board (110) and the second electronic component (122) (see FIGS. 2B and 3). For example, the plurality of protrusions (140) may be designed not to contact a lower surface of the second electronic component (122). For example, the protruding height h of the plurality of protrusions (140) may be designed within a range of 70 µm to (100) µm, but the disclosure is not limited thereto. For example, the gap g between the second electronic component (122) and the circuit board (110) may be designed within a range of (140) µm to 160 µm. For example, a gap between the plurality of protrusions (140) and the second electronic component

(122) may be designed within a range of 80 µm to 90 µm. In this case, interference between the plurality of protrusions (140) and the second electronic component (122) does not occur, so damage to the second electronic component (122) due to formation of the plurality of protrusions (140) may be prevented. However, the disclosure is not limited thereto, and in some examples, the protruding height h of the plurality of protrusions (140) may be designed to be substantially the same as the gap g between the circuit board (110) and the second electronic component (122) so that the plurality of protrusions (140) connect the circuit board (110) and the second electronic component (122).

According to an example, a size of the plurality of protrusions (140) may be formed to be smaller than the plurality of solder members (130). For example, a diameter of the plurality of protrusions (140) may be designed within a range of 0.1 mm to 0.2 mm, and a diameter of the plurality of solder members (130) may be designed to be about 0.3 mm, but the disclosure is not limited thereto. In this case, more of the plurality of protrusions (140) may be disposed than the plurality of solder members (130) within a limited area (e.g., the edge area PA), so capillary action may be smoother.

In an example, the plurality of protrusions (140) may adjust the filling amount and/or filling area (or filling range) of the filling member B filled in a space between the second electronic component (122) and the circuit board (110) by designing spacing between protrusions, arrangement of protrusions, and/or shape of protrusions in various ways, and may also enhance uniformity of the filling member B. Here, the uniformity of the filling member B may mean a degree to which the filling member B is evenly applied on the circuit board (110).

According to an example, the filling member B may physically connect the second electronic component (122) to the circuit board (110). In an example, the filling member B may be filled in liquid form in a gap between the circuit board (110) and the second electronic component (122) by an underfill process and/or a sidefill process. Thereafter, the filled filling member B may be cured by heat and/or pressure. In an example, the filling member B may be composed of a non-conductive material. For example, the filling member B may be composed of a thermosetting resin such as epoxy series, silicone series, polyurethane series, acrylic series, and polyamide series having insulating properties.

In an example, the filling member B may be evenly filled throughout the edge area PA along the plurality of protrusions (140) provided on the circuit board (110).

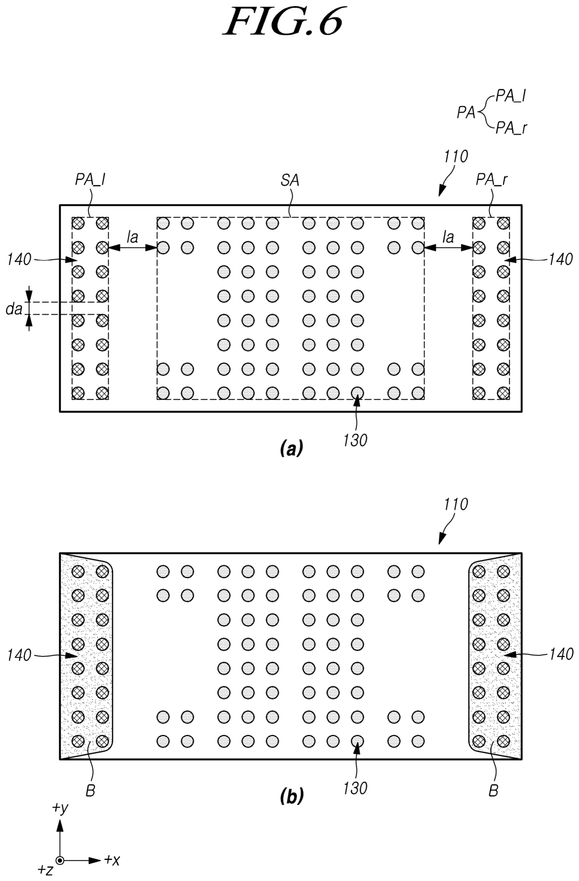

According to an example, the plurality of protrusions (140) may be disposed on the circuit board (110) in at least one or more rows. Hereinafter, various arrangement structures of the plurality of protrusions (140) is described with reference to FIGS. 6 to 16.

FIGS. 6 to 16 are views illustrating arrangements of a plurality of protrusions according to various embodiments of the disclosure.

FIGS. 6 to 16 are views illustrating the plurality of protrusions (140) disposed in at least one or more rows, e.g., two or more rows in a horizontal direction (e.g., ±x direction) on the circuit board (110).

FIG. 6(a) is a view illustrating the plurality of protrusions (140) disposed in a grid pattern shape in the edge area PA on the circuit board (110) in case of viewing the circuit board (110) from above (e.g., +z-axis direction). FIG. 6(b) is a view illustrating a filling state of the filling member B in case that the plurality of protrusions (140) are disposed as illustrated in FIG. 6(a).

Referring to FIG. 6(a), the plurality of protrusions (140) according to an example may be disposed to have at least two or more rows. In an example, each row of the plurality of protrusions (140) may be spaced apart at a predetermined interval along the horizontal direction (e.g., ±x-axis direction) of the circuit board (110).

In an example, the plurality of protrusions (140) may be disposed on each of left and right sides of the soldering area SA, spaced apart from the soldering area SA where the plurality of solder members (130) or connection pads (113a) are disposed. The edge area PA may also be formed on each of the left and right sides of the soldering area SA corresponding to the arrangement structure of the plurality of protrusions (140).

According to an example, the plurality of protrusions (140) may be disposed to have an overall grid pattern in the edge area PA in case of viewing the circuit board (110) from above (e.g., +z-axis direction). For example, the plurality of protrusions (140) included in each row may be disposed to face the plurality of protrusions (140) included in other adjacent rows. The plurality of protrusions (140) in each row may be spaced apart from each other by a predetermined spacing da. The spacing da of the plurality of protrusions (140) may be designed to be, e.g., about 0.4 mm, but the disclosure is not limited thereto.

In the grid pattern arrangement structure of the plurality of protrusions (140), a distance la between the soldering area SA and the edge area PA may be designed within a range of 0.9 mm to 2.0 mm, e.g., but the disclosure is not limited thereto.

Referring to FIG. 6(b), in case that the filling member B fills the edge area PA corresponding to the arrangement structure illustrated in FIG. 6(a), the filling member B may flow inward (e.g., in a direction toward the soldering area SA) along gaps formed between the plurality of protrusions (140) in a space between the second electronic component (e.g., the second electronic component (122) of FIG. 2A) and the circuit board (110) by capillary action and then be cured. In this case, the filling member B does not contact the plurality of solder members (130) due to the arrangement structure of the plurality of protrusions (140) and may be evenly filled within the periphery of the edge area PA.

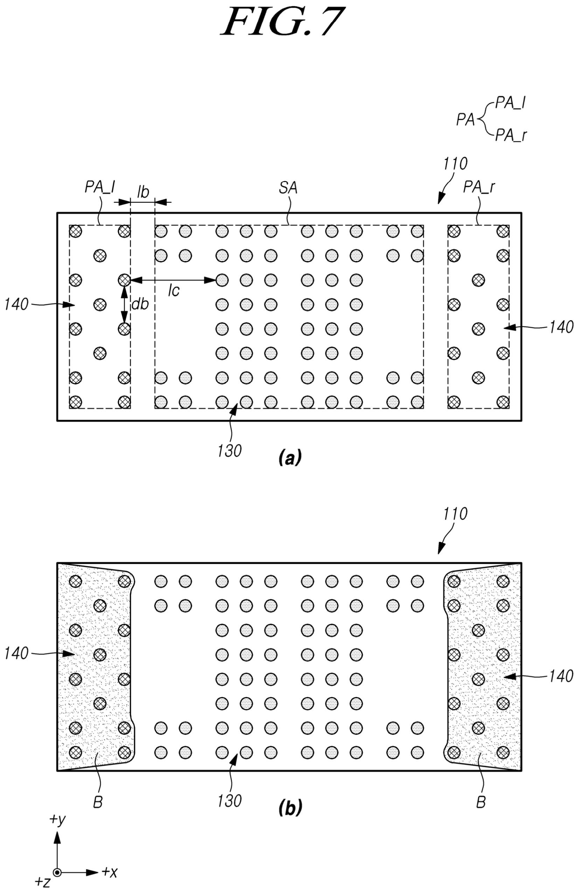

FIG. 7(a) is a view illustrating at least some of the plurality of protrusions (140) disposed in a cross pattern shape in the edge area PA on the circuit board (110) in case of viewing the circuit board (110) from above (e.g., +z-axis direction). FIG. 7(b) is a view illustrating a filling state of the filling member B in case that the plurality of protrusions (140) are disposed as illustrated in FIG. 7(a).

Referring to FIG. 7(a), the plurality of protrusions (140) according to an example may be disposed to have at least two or more, e.g., three rows. In an example, each row of the plurality of protrusions (140) may be spaced apart at a predetermined interval along the horizontal direction (e.g., ±x-axis direction) of the circuit board (110).

In an example, the plurality of protrusions (140) may be disposed on each of left and right sides of the soldering area SA, spaced apart from the soldering area SA where the plurality of solder members (130) are disposed. In this case, the edge area PA may also be formed on each of the left and right sides of the soldering area SA corresponding to the arrangement structure of the plurality of protrusions (140).

According to an example, at least some of the plurality of protrusions (140) may be disposed to have a repeating cross pattern (e.g., X-shaped pattern) along a vertical direction (e.g., ±y-axis direction) in case of viewing the circuit board (110) from above (e.g., +z-axis direction). For example, at least some of the plurality of protrusions (140) included in each row may be disposed not to face the plurality of protrusions (140) included in other adjacent rows. For example, the plurality of protrusions (140) included in each row may be alternately disposed with the plurality of protrusions (140) included in other adjacent rows.

In the cross pattern arrangement structure of the plurality of protrusions (140), each of the plurality of protrusions (140) included in each row may be spaced apart from each other by a predetermined spacing db. The spacing db of the plurality of protrusions (140) may be designed to be, e.g., about 1.0 mm, but the disclosure is not limited thereto.

In the cross pattern arrangement structure, a distance lb between the soldering area SA and the edge area PA may be designed within a range of 0.1 mm to 0.5 mm, for example. A distance lc between the solder member (130) disposed at an inner edge of the soldering area SA and the edge area PA may be designed within a range of 1.0 mm to 2.0 mm, for example. However, the disclosure is not limited thereto.

Comparing the arrangement structures of the plurality of protrusions (140) illustrated in each drawing with reference to FIGS. 7(b) and 6(b), as the number of rows in the arrangement structure of the plurality of protrusions (140) illustrated in FIG. 7(b) increases compared to the arrangement structure of the plurality of protrusions (140) illustrated in FIG. 6(b), a filling amount of the filling member B filled between the second electronic component (122) and the circuit board (110) may increase. Accordingly, the second electronic component (122) may be firmly mounted on the circuit board (110).

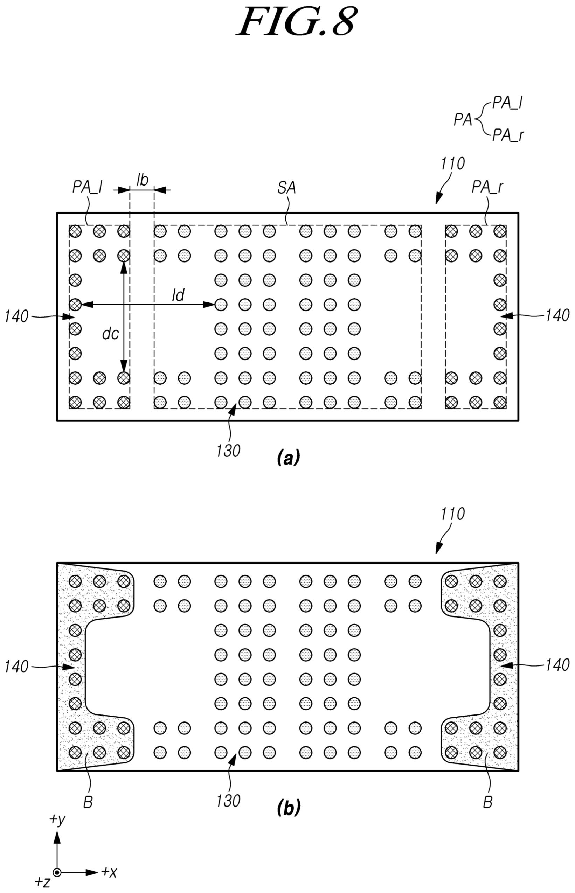

FIG. 8(a) is a view illustrating the plurality of protrusions (140) disposed in an overall " 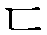 " shape or horizontally flipped " 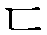 " shape on each of left and right sides of the soldering area SA in case of viewing the circuit board (110) from above (e.g., +z-axis direction). FIG. 8(b) is a view illustrating a filling state of the filling member B in case that the plurality of protrusions (140) are disposed as illustrated in FIG. 8(a).

Referring to FIG. 8(a), the plurality of protrusions (140) according to an example may be disposed to have at least two or more, e.g., three rows. In an example, each row of the plurality of protrusions (140) may be spaced apart at a predetermined interval along the horizontal direction (e.g., ±x-axis direction) of the circuit board (110).

In an example, the plurality of protrusions (140) may be disposed on each of left and right sides of the soldering area SA, spaced apart from the soldering area SA where the plurality of solder members (130) are disposed. In this case, the edge area PA may also be formed on each of the left and right sides of the soldering area SA corresponding to the arrangement structure of the plurality of protrusions (140).

According to an example, the plurality of protrusions (140) may be disposed to have an overall " 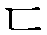 " shape or horizontally flipped " 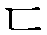 " shape on each of left and right sides of the soldering area SA in case of viewing the circuit board (110) from above (e.g., +z-axis direction). For example, the protrusions (140) may not be disposed in a central right area or central left area of the edge area PA. The plurality of protrusions (140) may be disposed to have a shape with a central portion concave toward the soldering area SA in case of viewing the circuit board (110) from above.

In the arrangement structure of the plurality of protrusions (140) illustrated in FIG. 8, a distance ld between the solder member (130) disposed at an inner edge of the soldering area SA and the protrusion (140) disposed at an outermost side of the edge area PA may be designed within a range of 1.5 mm to 3.0 mm, e.g., but the disclosure is not limited thereto.

A distance dc between an upper area (e.g., +y-axis area) and a lower area (e.g., -y-axis area) of the edge area PA may be designed to be about 10 mm, but the disclosure is not limited thereto.

Referring to FIG. 8(b), by designing the arrangement structure of the plurality of protrusions (140) corresponding to various arrangement structures of the plurality of solder members (130) in the soldering area SA, a filling direction (or flow direction) of the filling member B filled between the second electronic component (122) and the circuit board (110) may be controlled.

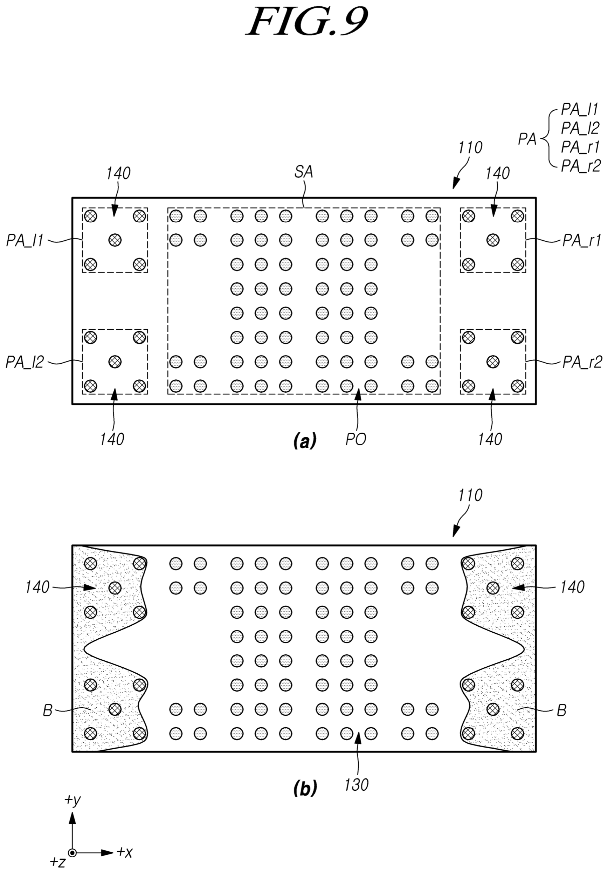

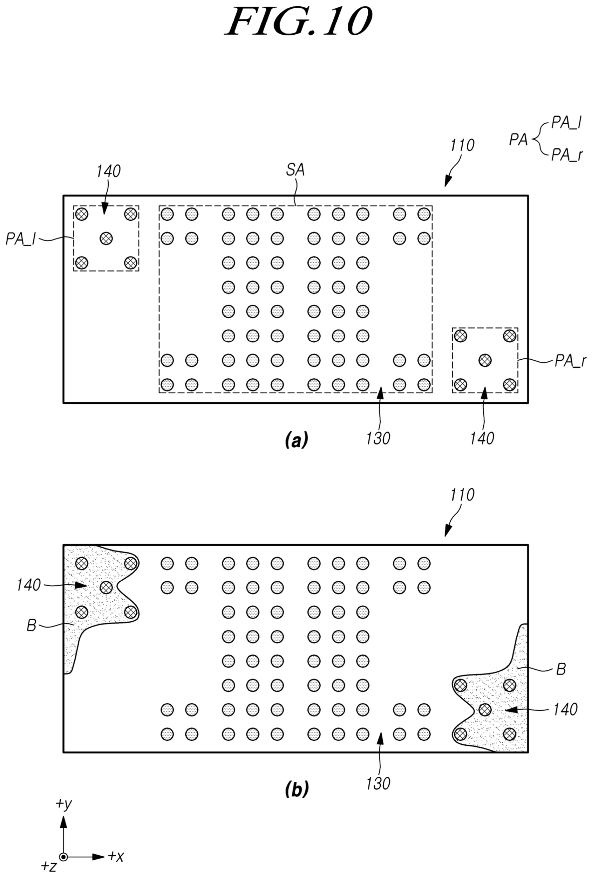

Referring to FIGS. 9 and 10, the plurality of protrusions (140) according to an example may be disposed in at least one group in an area of the circuit board (110) facing corner portions of an edge of the second electronic component (122). The plurality of protrusions (140) may be disposed to have an overall X shape within the group.

Referring to FIG. 9(a), the plurality of protrusions (140) may be disposed in groups at each of upper left, lower left, upper right, and lower right with respect to the soldering area SA in case of viewing the circuit board (110) from above (e.g., +z-axis direction). In this case, the edge area PA may also be divided into an upper left edge area PA_l1, a lower left edge area PA_l2, an upper right edge area PA_rl, and a lower right edge area PA_r2 corresponding to the arrangement structure of the plurality of protrusions (140). The upper left edge area PA_l1 and the lower left edge area PA_l2 may be disposed to be spaced apart at a predetermined interval in a vertical direction (e.g., ±y-axis direction) on a left side (e.g., -x-axis direction) of the soldering area SA. The upper right edge area PA_r1 and the lower right edge area PA_r2 may be disposed to be spaced apart at a predetermined interval in the vertical direction (e.g., ±y-axis direction) on a right side (e.g., +x-axis direction) of the soldering area SA.

Referring to FIG. 9(b), in case that the filling member B fills the edge area PA corresponding to the arrangement structure illustrated in FIG. 9(a), it may be identified that the filling member B is not filled in empty areas formed between the edge areas PA_l1, PA_l2, PA_r1, PA_r2 as they are spaced apart from each other. In this case, the filling member B may be filled between the second electronic component (122) and the circuit board (110) near four vertices of the second electronic component (122).

Referring to FIG. 10(a), unlike illustrated in FIG. 9(a), the plurality of protrusions (140) may be disposed in groups in diagonal directions with respect to the soldering area SA in case of viewing the circuit board (110) from above (e.g., +z-axis direction). For example, the plurality of protrusions (140) may be disposed in the upper left edge area PA_l1 and the lower right edge area PA_r2.

Referring to FIG. 10(b), in case that the filling member B fills the edge area PA corresponding to the arrangement structure illustrated in FIG. 10(a), it may be identified that the filling member B is filled centered on the upper left edge area PA_l1 and the lower right edge area PA _r2. In this case, the filling member B may be filled between the second electronic component (122) and the circuit board (110) near diagonal vertices of the second electronic component (122).

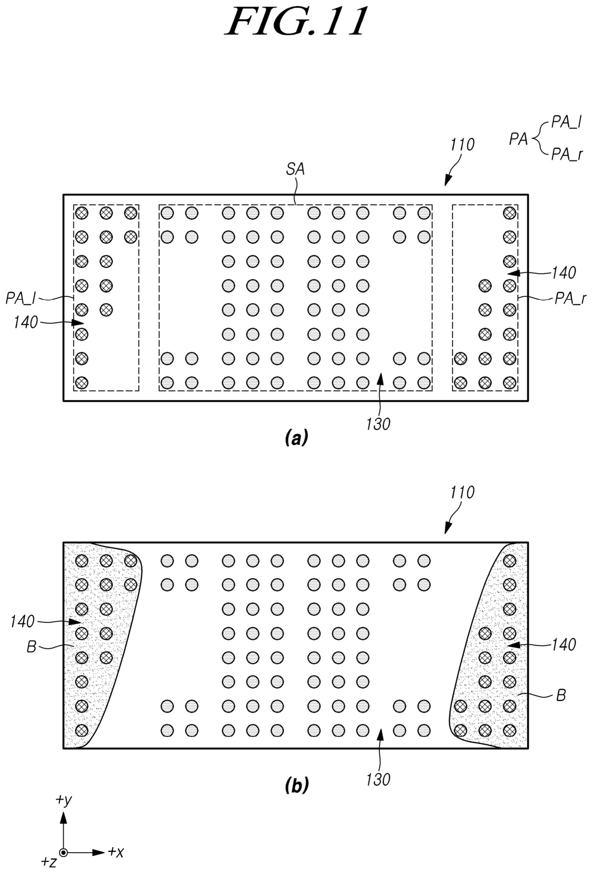

Referring to FIG. 11, the plurality of protrusions (140) may have an arrangement structure in which the number of the plurality of protrusions (140) gradually decreases in a predetermined direction (e.g., -y-axis direction or +y-axis direction).

Referring to FIG. 11(a), the plurality of protrusions (140) according to an example may have an arrangement structure in which the number of protrusions decreases in a first direction (e.g., -y-axis direction) in the first edge area PA_l in case of viewing the circuit board (110) from above (e.g., +z-axis direction). In an example, the plurality of protrusions (140) may have an arrangement structure in which the number of protrusions decreases in a second direction (e.g., +y-axis direction) opposite to the first direction in the second edge area PA_r in case of viewing the circuit board (110) from above (e.g., +z-axis direction). For example, the plurality of protrusions (140) may have an inclined arrangement structure or a right triangular arrangement structure in which the number of protrusions decreases or increases in each edge area PA in case of viewing the circuit board (110) from above.

Referring to FIG. 11(b), in case that the filling member B fills the edge area PA corresponding to the arrangement structure illustrated in FIG. 11(a), the filling member B is filled centered on the plurality of protrusions (140) and may be distributed in an oblique direction on the X-Y plane in case of viewing the circuit board (110) from above.

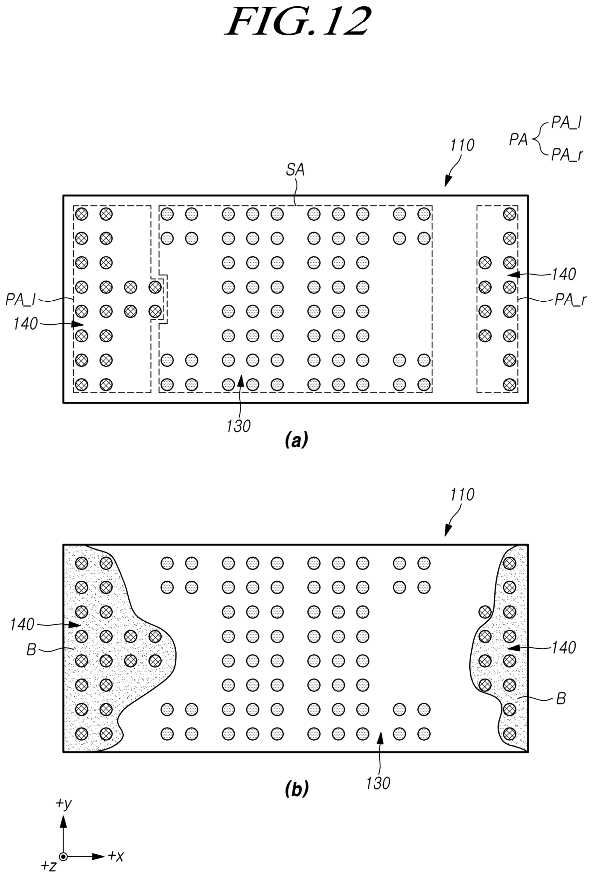

Referring to FIG. 12, the plurality of protrusions (140) according to an example may be disposed to have a left-right asymmetric structure with respect to the soldering area SA. In this case, areas of the first edge area PA_l and the second edge area PA_r formed on each of left and right sides of the soldering area SA may differ from each other.

Referring to FIG. 12(a), the plurality of protrusions (140) according to an example may be disposed in four rows in the first edge area PA_l. In an example, the plurality of protrusions (140) may be disposed to have an overall " 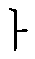 " shape in the first edge area PA_l in case of viewing the circuit board (110) from above (e.g., +z-axis direction). For example, the plurality of protrusions (140) may be disposed in four rows with a central portion of the first edge area PA_r convex toward the soldering area SA. In an example, the plurality of protrusions (140) may be disposed to have an overall " 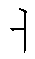 " shape in the second edge area PA_r in case of viewing the circuit board (110) from above (e.g., +z-axis direction). For example, the plurality of protrusions (140) may be disposed in two rows with a central portion of the second edge area PA_r convex toward the soldering area SA. In this case, an area of the first edge area PA_l may be larger than the second edge area PA_r.

Referring to FIG. 12(b), in case that the filling member B fills the edge area PA corresponding to the arrangement structure illustrated in FIG. 12(a), the filling member B is distributed toward a central portion side of each edge area PA_l, PA_r, and it may be identified that a distribution range of the filling member B is wider in the first edge area PA_l where more protrusions are formed than in the second edge area PA_r.

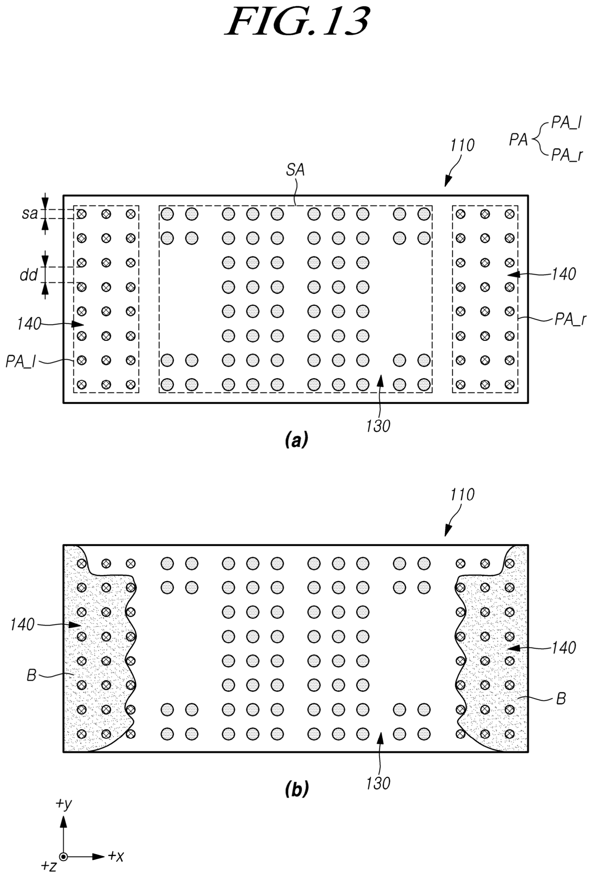

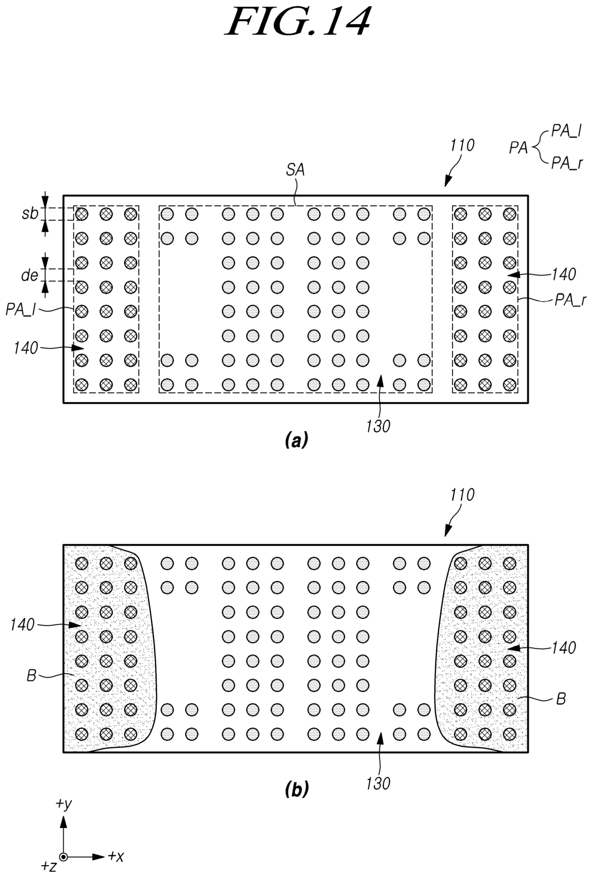

Referring to FIGS. 13 and 14, the plurality of protrusions (140) according to an example may adjust a distribution range of the filled filling member B by adjusting a size of the protrusions and/or spacing between the protrusions.

Referring to FIGS. 13(a) and 14(a), a diameter (or size) sa of the plurality of protrusions (140) illustrated in FIG. 13(a) may be designed to be smaller than a diameter (or size) sb of the plurality of protrusions (140) illustrated in FIG. 14(a). On the other hand, a spacing dd between the plurality of protrusions (140) illustrated in FIG. 13(a) may be designed to be wider than a spacing de between the plurality of protrusions (140) illustrated in FIG. 14(a).

In this case, a capillary effect by the plurality of protrusions (140) having the arrangement structure of FIG. 14(b) may be smoother than the arrangement structure of FIG. 13(a). Accordingly, it may be identified that the distribution range of the filling member B filled into the edge area PA is distributed wider in FIG. 14(b) than in FIG. 13(a).

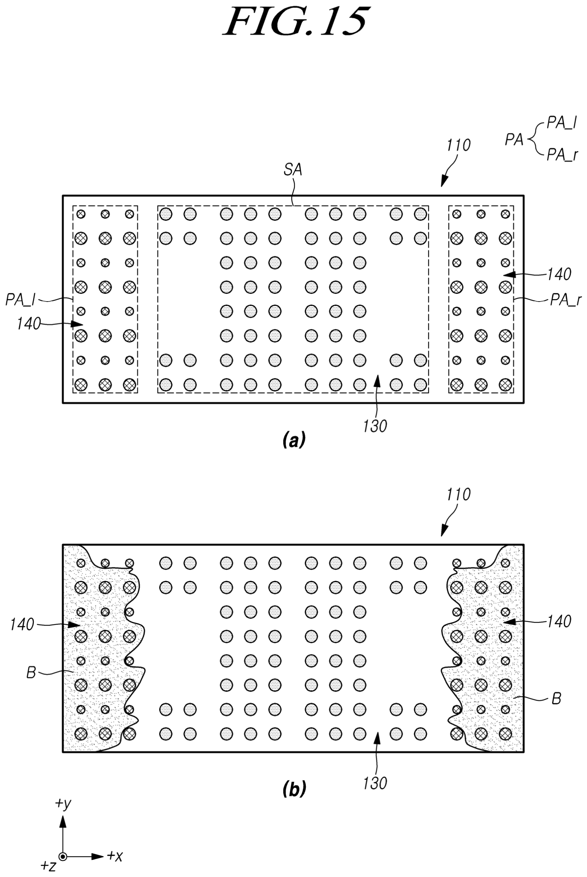

Referring to FIG. 15, in the plurality of protrusions (140) according to an example, protrusions of different sizes may be alternately disposed in each row disposed in the edge area PA. In an example, the size of protrusions included in each row in each edge area PA_l, PA_r may vary in a vertical direction (e.g., ±y-axis direction). For example, in the plurality of protrusions (140) included in each row, small-sized protrusions and large-sized protrusions may be alternately disposed in the vertical direction. In case that the filling member B fills the edge area PA corresponding to the arrangement structure illustrated in FIG. 15(a), as illustrated in FIG. 15(b), it may be identified that the filling member B is distributed centered on relatively larger protrusions. Such distribution pattern of the filling member B may be caused by a difference in adhesion area between the filling member B and the protrusions.

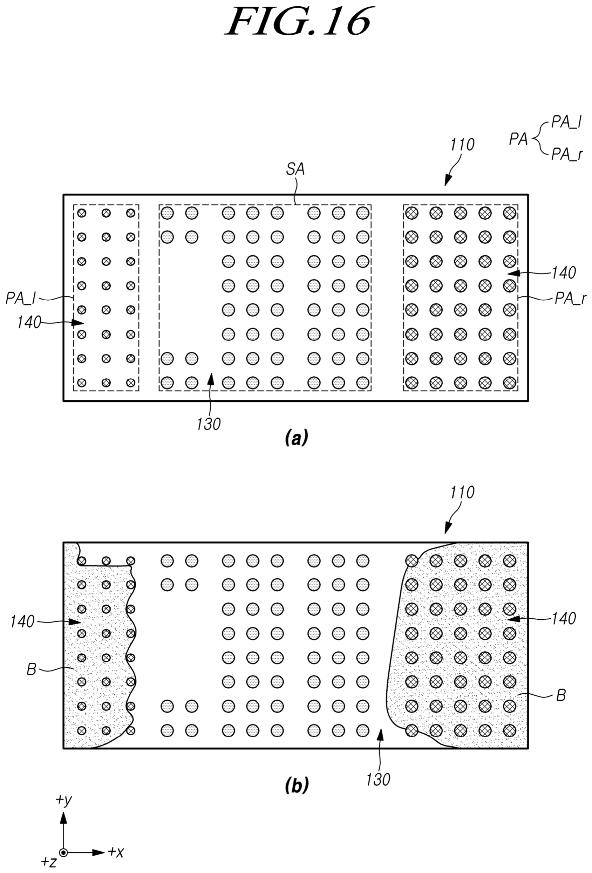

Referring to FIG. 16, in a soldering area SA' according to an example, in case of viewing the circuit board (110) from above (e.g., +z-axis direction), an overall left-right shape may be formed asymmetrically as an arrangement structure of the plurality of connection pads (113a) changes. In this case, the plurality of protrusions (140) according to an example may be disposed to have a left-right asymmetric structure with respect to the soldering area SA'. Further, areas of the first edge area PA_l and the second edge area PA_r formed on each of left and right sides of the soldering area SA' may differ from each other.

Referring to FIG. 16(a), the plurality of protrusions (140) according to an example may be disposed in three rows in the first edge area PA_1, but the disclosure is not limited thereto. In an example, the plurality of protrusions (140) may be disposed to have a grid pattern in the first edge area PA_l. According to an example, the plurality of protrusions (140) may be disposed in five rows in the second edge area PA_r, but the disclosure is not limited thereto. In an example, the plurality of protrusions (140) may be disposed to have a grid pattern in the second edge area PA_r. Further, the plurality of protrusions (140) disposed in the first edge area PA_l may be designed to have a smaller size than the plurality of protrusions (140) disposed in the second edge area PA_r.

In this case, as illustrated in FIG. 16(b), in case that the filling member B fills the edge area PA, it may be identified that the distribution range of the filling member B is wider in the second edge area PA_r than in the first edge area PA_l.

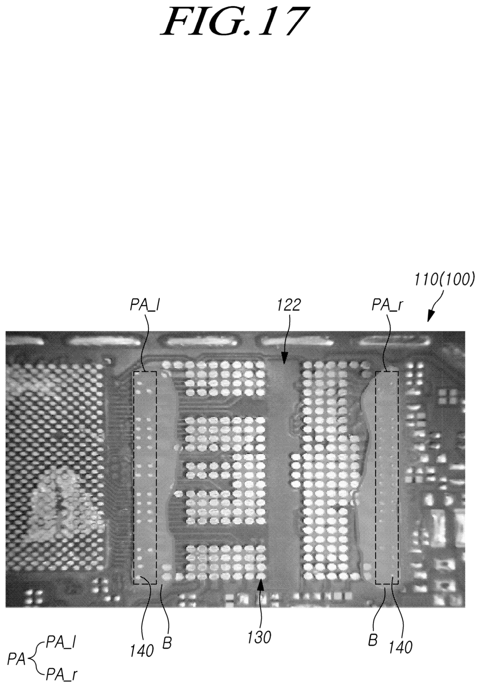

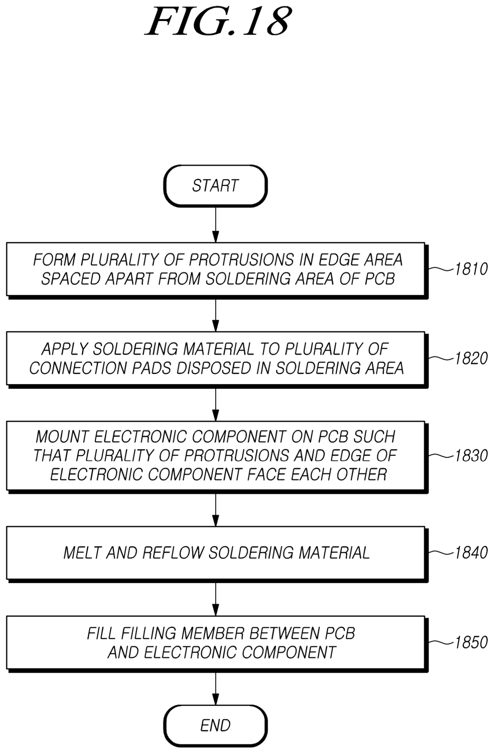

FIG. 17 is a view illustrating a filling range of a filling member on a circuit board according to an embodiment of the disclosure.

Referring to FIG. 17, as described above, by disposing the plurality of protrusions (140) in the edge area PA of the circuit board (110), the filling member B may be evenly filled throughout the edge area PA by capillary action in case of filling the filling member B. Further, contact between the filled filling member B and the plurality of solder members (130) disposed in the soldering area SA may be prevented as much as possible. In this case, electrical performance of the solder member (130) may be ensured, and at the same time, reliability in circumstances such as thermal shock or drop of the second electronic component (122) and the circuit board (110) may be enhanced.

FIG. 18 is a manufacturing process diagram illustrating a printed circuit board assembly according to an embodiment of the disclosure.

FIG. 19 is a process diagram illustrating a forming process of a plurality of protrusions according to an embodiment of the disclosure.

FIG. 20 is a process diagram illustrating a forming process of a plurality of protrusions according to an embodiment of the disclosure.

Referring to FIG. 18, a method for manufacturing the printed circuit board assembly (100) according to an example may include forming a plurality of protrusions (140) in the edge area PA spaced apart from the soldering area SA of the circuit board (110) (1810). For example, as described above, the plurality of protrusions (140) may be formed by a soldering process of applying and/or curing a soldering material on the plurality of dummy pads (113b) provided on the circuit board (110).

According to an example, the plurality of protrusions (140) may not only be formed by the soldering process but also may be formed by a bonding member P composed of a material different from the soldering material. Hereinafter, a forming process of the protrusions (140) using the bonding member (or bonding solution) P is described with reference to FIGS. 19 and 20.

FIG. 19(a) is a view illustrating the bonding member P being dispensed on the circuit board (110) by the dispensing device (200). FIG. 19(b) is a view illustrating the second electronic component (122) being mounted (or disposed) on the circuit board (110) after the bonding member P dispensed on the circuit board (110) of FIG. 19(a) is cured to form the plurality of protrusions (140).

Referring to FIG. 19(a), an operator may apply the bonding member P to an area of the circuit board (110) where the plurality of solder members (130) are not disposed before mounting the second electronic component (122) using the dispensing device (or dispenser) (200).

Referring to FIG. 19(b), the operator may apply the bonding member P to the circuit board (110) and then cure it to form the plurality of protrusions (140), and then mount (or dispose) the second electronic component (122) on the circuit board (110) such that the plurality of protrusions (140) and an edge portion of the second electronic component (122) face each other while the plurality of solder members (130) are seated on the connection pads (113a) of the circuit board (110).

Thereafter, although not specifically illustrated in the drawings, the operator may fill the filling member B to an edge of the second electronic component (122) and the circuit board (110). In this case, the filled filling member B may flow into an inner space between the second electronic component (122) and the circuit board (110) through the plurality of protrusions (140) and then be cured.

FIG. 20(a) is a view illustrating the bonding member P being dipped from an external storage container by the stamping device (300) and stamped on the circuit board (110). FIG. 20(b) is a view illustrating the second electronic component (122) being mounted (or disposed) on the circuit board (110) after the bonding member P stamped on the circuit board (110) of FIG. 20(a) is cured to form the plurality of protrusions (140).

Referring to FIG. 20(a), the operator may dip the bonding member P from an external container storing the bonding member P using the stamping device (300), and then apply the bonding member P to an area of the circuit board (110) where the plurality of solder members (130) are not disposed before mounting the second electronic component (122).

Referring to FIG. 20(b), the operator may apply the bonding member P to the circuit board (110) and then cure it to form the plurality of protrusions (140), and then mount (or dispose) the second electronic component (122) on the circuit board (110) such that the plurality of protrusions (140) and an edge portion of the second electronic component (122) face each other while the plurality of solder members (130) are seated on the connection pads (113a) of the circuit board (110).

Thereafter, although not specifically illustrated in the drawings, the operator may fill the filling member B to an edge of the second electronic component (122) and the circuit board (110). In this case, the filled filling member B may flow into an inner space between the second electronic component (122) and the circuit board (110) through the plurality of protrusions (140) and then be cured.

As described with reference to FIGS. 19 and 20, in case of forming the plurality of protrusions (140) using the bonding member P, the dummy pads (113b) for fixing the soldering material required during the soldering process become unnecessary, so design freedom of the circuit board (110) may be enhanced.

According to an example, the method for manufacturing the printed circuit board assembly (100) may include applying a soldering material to the plurality of connection pads (113a) disposed in the soldering area SA (1820).

According to an example, the method for manufacturing the printed circuit board assembly (100) may mounting (or disposing) the electronic component (e.g., the second electronic component 122) on the circuit board (110) such that the plurality of protrusions (140) and an edge of the electronic component (122) face each other. In this case, each of the plurality of contact points (125) of the electronic component (122) and the plurality of connection pads (113a) of the circuit board (110) may contact upper/lower portions of the plurality of solder members (130).

According to an example, the method for manufacturing the printed circuit board assembly (100) may include melting and reflowing the soldering material by applying heat to the plurality of solder members (130) in a state in which the electronic component (122) is mounted (or disposed) on the circuit board (110) (1840). In this case, the electronic component (122) and the circuit board (110) may be physically and/or electrically connected through the plurality of solder members (130) by melting and then curing the soldering material.

According to an example, the method for manufacturing the printed circuit board assembly (100) may include filling the filling member B between the circuit board (110) and the electronic component (122) (1850). For example, the operator may perform an underfill or sidefill process of filling the filling member B into a space between an edge of the electronic component (e.g., the second electronic component 122) where the plurality of protrusions (140) are located and the circuit board (110). In this case, the filling member B may seep along narrow gaps formed between the plurality of protrusions (140) by capillary action and be evenly distributed in the edge area where the plurality of protrusions (140) are formed.

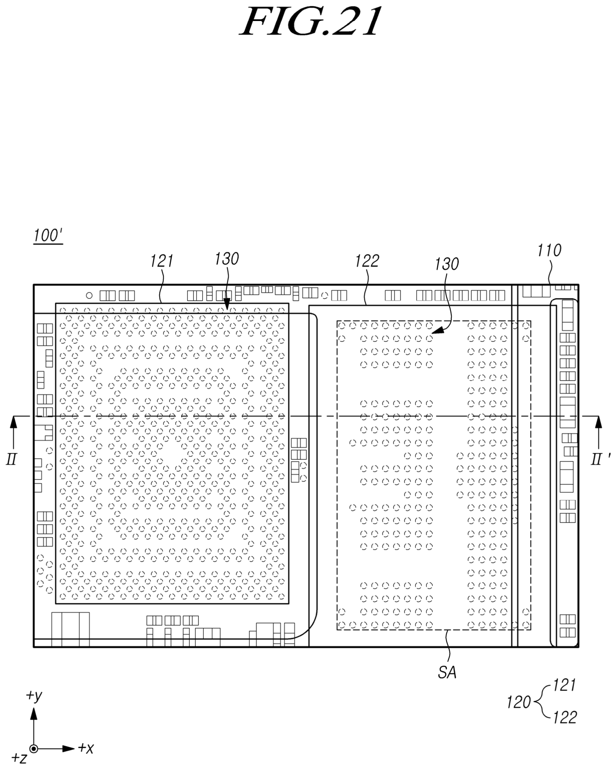

FIG. 21 is a plan view illustrating a printed circuit board assembly according to a comparative embodiment of the disclosure.

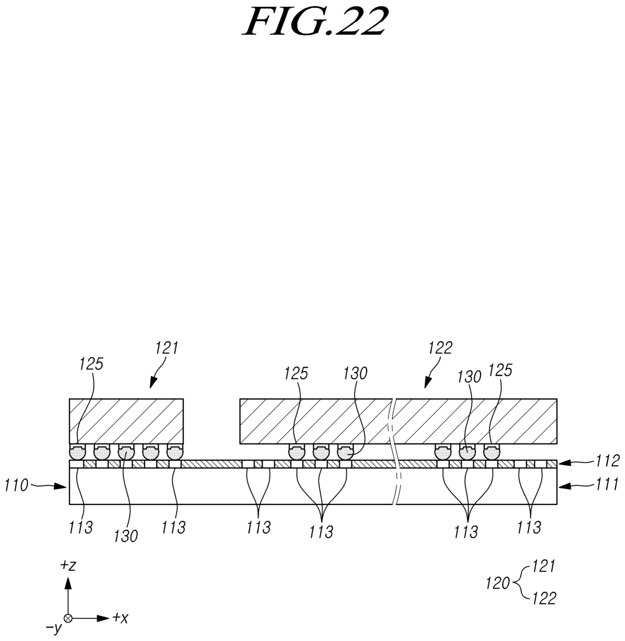

FIG. 22 is a cross-sectional view illustrating the printed circuit board assembly taken along line II-II' illustrated in FIG. 21 according to a comparative embodiment of the disclosure;

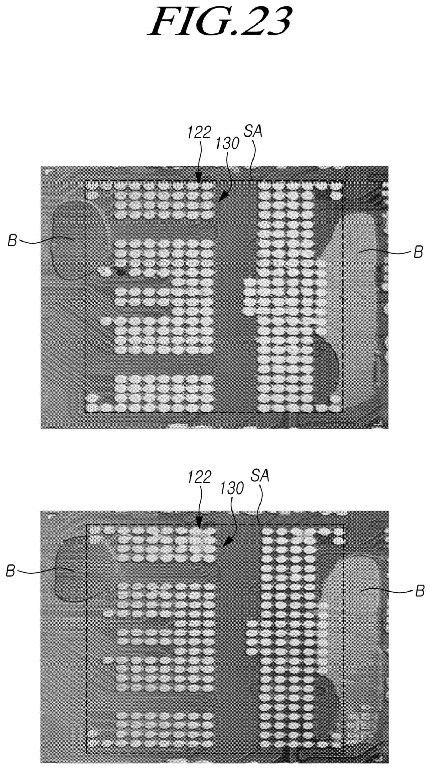

FIG. 23 is a view illustrating a filling range of a filling member in a circuit board according to a comparative embodiment of the disclosure.

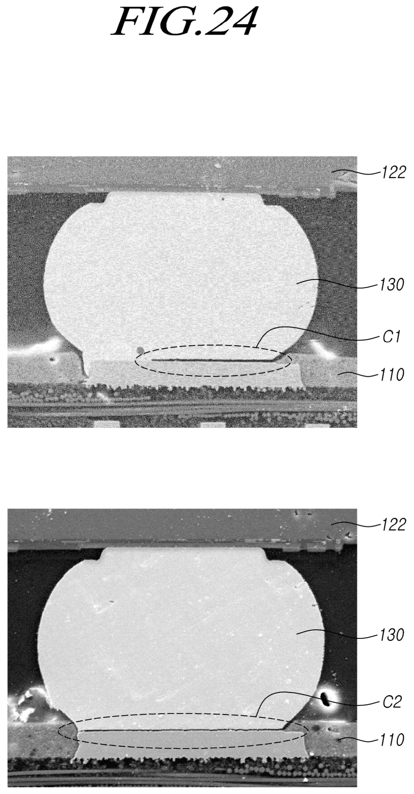

FIG. 24 is a view illustrating a crack state of a solder member occurring in case that a filling member is under-filled.

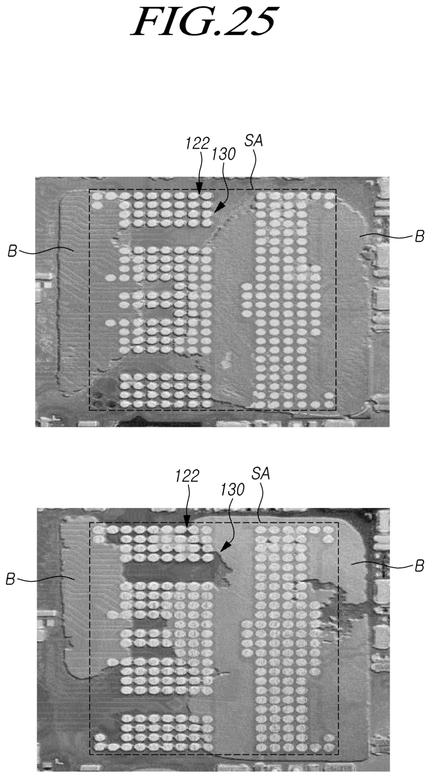

FIG. 25 is a view illustrating a filling range of a filling member on a circuit board according to a comparative embodiment of the disclosure.

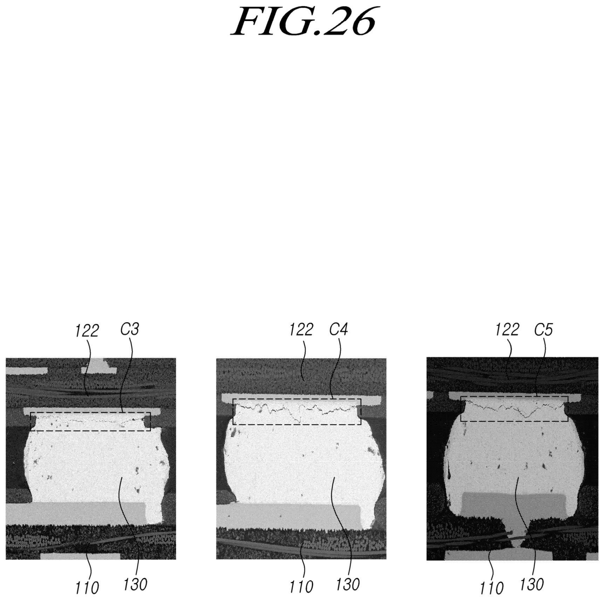

FIG. 26 is a view illustrating a crack state of a solder member occurring in case that a filling member is over-filled.

Referring to FIGS. 21 and 22, a printed circuit board assembly (100') according to the comparative example may include the circuit board (110), at least one electronic component (120), and/or the plurality of solder members (130). In describing the printed circuit board assembly (100') illustrated in FIGS. 21 and 22, the same reference numerals are assigned to components substantially the same as or similar to the printed circuit board assembly (100) illustrated in FIGS. 1 and 2, and the description of the components may be replaced with the description of the printed circuit board assembly (100).

In the printed circuit board assembly (100') according to the comparative example, the soldering area SA where the plurality of solder members (130) connecting the second electronic component (122) and the circuit board (110) are disposed may be smaller than an overall size of the second electronic component (122).

Unlike the printed circuit board assembly (100) according to an example of the disclosure illustrated in FIGS. 1 and 2, the printed circuit board assembly (100') according to the comparative example does not have a plurality of protrusions (e.g., the plurality of protrusions (140) of FIG. 1) provided in a periphery of the soldering area SA on the circuit board (110), specifically in an edge area (e.g., the edge area PA of FIG. 1).

Referring to FIGS. 23 to 26, in the printed circuit board assembly (100') according to the comparative example, in case of filling the filling member B in a space between the second electronic component (122) and the circuit board (110) after mounting (or disposing) the second electronic component (122) on the circuit board (110), the filling member B frequently fails to be uniformly applied in an overlapping area between the second electronic component (122) and the circuit board (110) including the soldering area SA.

In case that the filling member B is under-filled as illustrated in FIG. 23, the filling member B may not sufficiently protect the plurality of solder members (130), and cracks (C1, C2 in FIG. 24) occur in the solder member (130) due to repeated external impacts or stress. As a result, the printed circuit board assembly (100') according to the comparative example has lower reliability in circumstances such as drops compared to the printed circuit board assembly (100) according to the disclosure.

Conversely, in case that the filling member B is over-filled as illustrated in FIG. 25, cracks (C3, C4, C5 in FIG. 26) occur in the solder member (130) due to thermal expansion/contraction of the filling member B according to heat generation of the solder member (130) during operation of the printed circuit board assembly. As a result, the printed circuit board assembly (100') according to the comparative example has lower reliability regarding thermal shock compared to the printed circuit board assembly (100) according to the disclosure.

A printed circuit board assembly (100) according to an example of the disclosure may include an electronic component (120). The printed circuit board assembly (100) may include a printed circuit board (PCB) (110) on which the electronic component (120) is disposed. The printed circuit board assembly (100) may include a plurality of solder members (130) electrically connecting the electronic component (120) and the printed circuit board (110) between the electronic component (120) and the printed circuit board (110). The plurality of protrusions (140) may be disposed on the printed circuit board (110) to be spaced apart from the plurality of solder members (130) and positioned near an edge of the electronic component (120). The printed circuit board assembly (100) may include a filling member B filling the edge of the electronic component (120) between the printed circuit board (110) and the electronic component (120). Distribution of the filling member B may be facilitated by an adhesion force between the filling member B and the plurality of protrusions (140), and a cohesion force of filling the filling member B during the filling of the filling member B in a liquid state between the printed circuit board (110) and the electronic component (120).

According to an example, the distribution of the filling member B may be controlled by at least one of a size of the plurality of protrusions (140), a distance between the plurality of solder members (130) and the plurality of protrusions (140), or a gap between the plurality of protrusions (140) such that the filling member B does not contact the plurality of solder members (130).

According to an example, the filling member B may be formed of at least one of epoxy, silicone, polyurethane, acrylic, or polyamide series which are non-conductive materials.

According to an example, a spacing distance between the plurality of protrusions (140) and the plurality of solder members (130) may be set to 0.1 mm or more such that the filling member B does not contact the plurality of solder members (130) during distribution of the filling member B.

According to an example, the plurality of solder members (130) may be disposed inside the edge of the electronic component (120) on the printed circuit board (110).

According to an example, the plurality of protrusions (140) may have a smaller size than the plurality of solder members (130) such that the filling member B does not contact the plurality of solder members (130) during distribution of the filling member B.

According to an example, each of the plurality of protrusions (140) may have a shape of one of a hemisphere, a cylinder, or a polyhedron.

According to an example, the plurality of protrusions (140) may have a lower height h than the plurality of solder members (130) so as not to contact the electronic component (120).

According to an example, the plurality of protrusions (140) are disposed in two or more rows, and the plurality of protrusions (140) included in each row may be disposed alternately with the plurality of protrusions (140) included in other adjacent rows.

According to an example, the plurality of protrusions (140) are disposed in two or more rows, and the plurality of protrusions (140) included in each row may be disposed to face the plurality of protrusions (140) included in other adjacent rows.

According to an example, the plurality of protrusions (140) are disposed to be spaced apart from each other at a predetermined interval, and a spacing d between the plurality of protrusions may be set to 0.4 mm or more such that the filling member B does not contact the plurality of solder members (130) during distribution of the filling member B.

According to an example, the printed circuit board (110) may include a plurality of connection pads (113a) on which each of the plurality of solder members (130) is disposed and a plurality of dummy pads (113b) on which each of the plurality of protrusions (140) is disposed. Each of the plurality of protrusions (140) may be formed by a soldering process disposing a soldering material on each of the plurality of dummy pads (113b).

According to an example, the plurality of protrusions (140) may be formed by dispensing a bonding member P at predetermined intervals along an outer area of the plurality of solder members (130) by a dispensing device (200) on the printed circuit board (110).

According to an example, the plurality of protrusions (140) may be formed by dipping a bonding member P from an external storage container by a stamping device (300), and then the bonding member P is stamped at predetermined intervals along an outer area of the plurality of solder members (130) by the stamping device (300).

A method for manufacturing a printed circuit board assembly (100) including a printed circuit board (110) on which an electronic component (120) is disposed according to an example of the disclosure may include forming 1810 a plurality of protrusions (140) in an edge area PA of the printed circuit board (110) spaced apart from a soldering area SA of the printed circuit board (110) where a plurality of solder members (130) are disposed. The method for manufacturing the printed circuit board assembly (100) may include applying (1820) a soldering material to a plurality of connection pads (113a) disposed in the soldering area SA. The method for manufacturing the printed circuit board assembly (100) may include disposing (1830) the electronic component (120) on the printed circuit board (110) such that the plurality of protrusions (140) and an edge of the electronic component (120) face each other. The method for manufacturing the printed circuit board assembly (100) may include filling (1850) a filling member B between the plurality of protrusions (140). Distribution of the filling member B may be facilitated by adhesion between the filling member B and the plurality of protrusions (140) and cohesion of the filling member B while the filling member B in a liquid state fills between the printed circuit board (110) and the electronic component (120).

According to an example, the method for manufacturing the printed circuit board assembly (100) may further include melting and reflowing (1840) the soldering material to electrically connect the electronic component (120) mounted on the printed circuit board (110) and the printed circuit board (110).

According to an example, the distribution of the filling member B may be controlled by at least one of a size of the plurality of protrusions (140), a distance between the plurality of solder members (130) and the plurality of protrusions (140), and a gap between the plurality of protrusions (140) such that the filling member B does not contact the plurality of solder members (130).

According to an example, the printed circuit board (110) may include a plurality of connection pads (113a) on which each of the plurality of solder members (130) is disposed and a plurality of dummy pads (113b) on which each of the plurality of protrusions (140) is disposed. Each of the plurality of protrusions (140) may be formed by a soldering process disposing a soldering material on each of the plurality of dummy pads (113b).

According to an example, the plurality of protrusions (140) may be formed by dispensing a bonding member P at predetermined intervals along an outer area of the plurality of solder members (130) by a dispensing device (200) on the printed circuit board (110).

According to an example, the plurality of protrusions (140) may be formed by dipping a bonding member P from an external storage container by a stamping device (300), and then the bonding member P is stamped at predetermined intervals along an outer area of the plurality of solder members (130) by the stamping device (300).

## Claims

1. A printed circuit board assembly (100) comprising:
an electronic component (120);
a printed circuit board (PCB) (110) on which the electronic component (120) is disposed;
a plurality of solder members (130) electrically connecting the electronic component (120) and the PCB (110) between the PCB (110) and the electronic component (120);
a plurality of protrusions (140) disposed to be spaced apart from the plurality of solder members (130) on the PCB (110) and positioned near an edge of the electronic component (120); and
a filling member B filling the edge of the electronic component (122) between the PCB (110) and the electronic component (120),
wherein distribution of the filling member B is facilitated by:
an adhesive force between the filling member B and the plurality of protrusions (120), and
a cohesive force of the filling member B during filling of the filling member B in a liquid state between the PCB (110) and the electronic component (120).

2. The printed circuit board assembly (100) according to claim 1, wherein the distribution of the filling member B is controlled by at least one of a size of the plurality of protrusions (140), a distance between the plurality of solder members (130) and the plurality of protrusions (140), or a gap between the plurality of protrusions (140) such that the filling member B does not contact the plurality of solder members (130).

3. The printed circuit board assembly (100) according to claim 1 or 2, wherein the filling member B is formed of at least one of epoxy, silicone, polyurethane, acrylic, or polyamide series, which are non-conductive materials.

4. The printed circuit board assembly (100) according to any one of claims 1 to 3, wherein a spacing distance between the plurality of protrusions (140) and the plurality of solder members (130) is set to 0.1mm or more such that the filling member B does not contact the plurality of solder members (130) when the filling member B is distributed.

5. The printed circuit board assembly (100) according to any one of claims 1 to 4, wherein the plurality of solder members (130) are disposed inside the edge of the electronic component (120).

6. The printed circuit board assembly (100) according to any one of claims 1 to 5, wherein the plurality of protrusions (140) has a smaller size than the plurality of solder members (130) such that the filling member B does not contact the plurality of solder members (130) when the filling member B is distributed.

7. The printed circuit board assembly (100) according to any one of claims 1 to 6, wherein each of the plurality of protrusions (140) has a hemispherical shape, a cylinder shape, or polyhedron shape.

8. The printed circuit board assembly (100) according to any one of claims 1 to 7, wherein each of the plurality of protrusions (140) has a height h lower than that of the plurality of solder members (130) so as not to contact the electronic component (120).

9. The printed circuit board assembly (100) according to any one of claims 1 to 8, wherein the plurality of protrusions (140) are arranged in two or more columns, and a plurality of protrusions (140) included in each column are alternately arranged with a plurality of protrusions (140) included in other adjacent columns.

10. The printed circuit board assembly (100) according to any one of claims 1 to 8,
wherein the plurality of protrusions (140) are arranged in two or more columns, and
wherein a plurality of protrusions (140) included in each column are arranged to face a plurality of protrusions (140) included in another adjacent column.

11. The printed circuit board assembly (100) according to any one of claims 1 to 10,
wherein the plurality of protrusions (140) are arranged spaced apart from each other by a predetermined distance, and
wherein the distance d between the plurality of protrusions (140) is set to 0.4 mm or more such that the filling member B does not contact the plurality of solder members (130) when the filling member B is distributed.

12. The printed circuit board assembly (100) according to any one of claims 1 to 11,
wherein the circuit board (110) includes a plurality of connection pads (113a) on which each of the plurality of solder members (130) is disposed and a plurality of dummy pads (113b) on which each of the plurality of protrusions (140) is disposed, and
wherein each of the plurality of protrusions (140) is formed by a soldering process of disposing a solder material on each of the plurality of dummy pads (113b).

13. The printed circuit board assembly (100) according to any one of claims 1 to 11, wherein the plurality of protrusions (140) are formed by dispensing a bonding member P at predetermined intervals along an outer region of the plurality of solder members (130) by a dispensing device (200) on the circuit board (110).

14. The printed circuit board assembly (100) according to any one of claims 1 to 11, wherein the plurality of protrusions (140) are formed by:
dipping a bonding member P from an external storage container by a stamping device (300), and
stamping the bonding member P at predetermined intervals along an outer region of the plurality of solder members (130) by the stamping device (300).

15. A method of manufacturing a printed circuit board assembly (100) including a printed circuit board (110) on which an electronic component (120) is mounted, the method comprising:
forming a plurality of protrusions (140) on an edge area PA of the printed circuit board (110) spaced apart from a soldering area SA of the printed circuit board (110) where a plurality of solder members (130) are disposed;
applying a soldering material to a plurality of connection pads (113a) disposed in the soldering area SA;
mounting the electronic component (120) on the printed circuit board (110) so such that the plurality of protrusions (140) and an edge of the electronic component (120) face each other; and
filling a filling member B with the plurality of protrusions (140) disposed between the mounted electronic component (120) and the printed circuit board (110),
wherein distribution of the filling member B is facilitated by:
an adhesive force between the filling member B and the plurality of protrusions (120); and
a cohesive force of the filling member B during filling of the filling member B in a liquid state between the PCB (110) and the electronic component (120).
